# EUROPEAN PATENT APPLICATION

(11) **EP 2 413 663 A1**
(43) Date of publication of application: **01.02.2012**
(21) Application number: 10756076.5
(22) Date of filing: 23.03.2010
(51) Int. Cl.: H05B 33/10, H01L 51/50

(54) **COATING SOLUTION FOR ORGANIC ELECTROLUMINESCENT ELEMENT**

(30) Priority: 27.03.2009 JP 2009080269; 19.08.2009 JP 2009190481
(71) Applicant: FUJIFILM Corporation, Tokyo 106-0031 (JP)
(72) Inventor: HAYASHI, Naoyuki, Ashigarakami-gun Kanagawa (JP); KATO, Takashi, Ashigarakami-gun Kanagawa (JP)
(74) Representative: HOFFMANN EITLE
(86) International application number: PCT/JP2010/055012
(87) International publication number: WO 2010/110280

(57) **Abstract**

To provide a coating liquid for organic electroluminescence device capable of fabricating an organic electroluminescence device with satisfactory durability and excellent efficiency.

A coating liquid for organic electroluminescence device for forming an organic layer including a light emitting layer between a pair of electrodes, in which a first solvent and a second solvent are contained; the first solvent is at least one member selected from solvents capable of dissolving a light emitting material and a host material contained in the light emitting layer and having a boiling point of 200°C or higher; the second solvent is at least one member selected from solvents having an azeotropic temperature with water of 99°C or less; and a relation between a boiling point (BP1) of the first solvent and a boiling point (BP2) of the second solvent is BP1 ≥ BP2.

## Description

### TECHNICAL FIELD

The present invention relates to a coating liquid for organic electroluminescence device.

### BACKGROUND ART

With respect to devices utilizing an organic material, studies regarding an organic electroluminescence device (hereinafter sometimes as "OLED"), a transistor utilizing an organic semiconductor, and the like are actively carried out. In particular, organic electroluminescence devices are expected to be developed for large-area full-color display devices of a solid emission type or illumination applications as an inexpensive large-area surface light source. In general, an organic electroluminescence device includes an organic layer including a light emitting layer and a pair of counter electrodes interposing the organic layer therebetween. When a voltage is impressed to such an organic electroluminescence device, an electron is injected from a cathode, and a hole is injected from an anode, respectively into the organic layer. The electron and the hole are recombined in the light emitting layer, and at the time when an energy level returns from a conduction band to a valence band, energy is released as light, thereby obtaining light emission.

In the manufacture of an organic electroluminescence device, as a method of forming a thin film that is an organic layer to be provided between a pair of electrodes, vacuum vapor deposition is carried out as a vapor deposition method; and a spin coating method, a printing method, an inkjet method or the like is carried out as a wet method.

Above all, when a wet method is adopted, it becomes possible to use an organic polymer compound which is difficult for film formation according to a dry process such as vapor deposition and the like, and in the case of being used for flexible displays or the like, the wet method is suitable from the standpoint of durability such as flexural resistance, film strength and the like, and especially preferable in the case of realizing a large area.

But, the wet method involves such problems that uniformity in film thickness of an organic thin film is insufficient due to a surface tension of solution; and that in the case of stacking organic layers, the respective organic layers are dissolved at an interface.

In order to solve the foregoing problems, there have been made various investigations. In order to solve the uniformity in film thickness of an organic thin film, Patent Document 1 describes a method in which a coating liquid is coated in a given thickness in each of a first coating step and a second coating step.

Also, organic electroluminescence devices obtained by a wet method involved such a problem that they are inferior in light emission efficiency or device durability. As a cause of bringing about deterioration of the light emission efficiency or device durability, moisture and oxygen may be considered. It may be considered that aggregation or crystallization of an organic EL layer is advanced due to the moisture, so that the device is deteriorated. Also, it may be considered that oxidation of the organic EL layer by oxygen causes the generation and growth of a so-called dark spot and deterioration in luminance with time.

Then, for the purpose of removing initial moisture and oxygen in the inside of an organic EL device stacked by a wet method, Patent Document 2 describes a method for manufacturing an organic EL device by using a coating liquid prepared in an inert gas having a few moisture content and a low oxygen concentration to obtain an organic thin film layer.

Patent Document 3 discloses an organic EL device having high external quantum efficiency, long life and low driving voltage by forming at least one of organic compound layers upon coating by a coating method with a dispersion liquid, followed by a smoothing treatment and describes in its working examples that a dispersion liquid having a hole transport material and a light emitting material dispersed in an alcohol is subjected to film formation by means of a spin coating method. Also, Patent Document 3 describes that although a solution having a host material and a light emitting material dissolved in a halogen based solvent was subjected to film formation by means of a spin coating method, satisfactory results were not obtained in all of the external quantum efficiency, light emission life and driving voltage.

### DOCUMENTS IN BACKGROUND ART

### PATENT DOCUMENTS

Patent Document 1: JP-A-2006-239628
Patent Document 2: JP-A-2004-55225
Patent Document: WO06/117914

### SUMMARY OF THE INVENTION

### PROBLEMS TO BE SOLVED BY THE INVENTION

However, the method of Patent Document 2 was insufficient from the standpoints of durability and efficiency of the device.

In the method of Patent Document 3, since the dispersion liquid is used, there was involved such a problem that satisfactory durability and efficiency are not obtained possibly for a reason that the state of film is heterogeneous due to a difference in dispersibility of each of the materials to be dispersed, or the like.

A problem to be solved by the invention is to solve the foregoing conventional problems and achieve the following objects.

That is, an object of the invention is to provide a coating liquid for organic electroluminescence device capable of fabricating an organic electroluminescence device with satisfactory durability and excellent efficiency by a coating liquid having a light emitting material and a host material dissolved in a specified solvent.

Another object of the invention is to provide a method for manufacturing an organic electroluminescence device with satisfactory durability and excellent efficiency.

A further object of the invention is to provide an organic electroluminescence device with satisfactory durability and excellent efficiency.

### MEANS FOR SOLVING THE PROBLEMS

Under the foregoing circumstances, the present inventors made extensive and intensive investigations. As a result, they have obtained knowledge that the foregoing problems can be solved by a coating liquid for organic electroluminescence device containing a mixed solvent of a first solvent that is at least one member selected from solvents capable of dissolving a light emitting material and a host material contained in a light emitting layer and having a boiling point of 200°C or higher; and a second solvent that is at least one member selected from solvents having an azeotropic temperature with water of 99°C or less, and then made further investigations on the basis of this knowledge, leading to accomplishment of the invention.

That is, the means for solving the foregoing problems are as follows.
[1] A coating liquid for organic electroluminescence device for forming an organic layer including a light emitting layer between a pair of electrodes, which comprises a first solvent and a second solvent,
   wherein
   the first solvent is at least one member selected from solvents capable of dissolving a light emitting material and a host material contained in the light emitting layer and having a boiling point of 200°C or higher,
   the second solvent is at least one member selected from solvents having an azeotropic temperature with water of 99°C or less, and
   a relation between a boiling point (BP1) of the first solvent and a boiling point (BP2) of the second solvent is BP1 ≥ BP2.
[2] The coating liquid for organic electroluminescence device according to [1], wherein a mass ratio of used amounts of the first solvent and the second solvent is from 50:50 to 95:5.
[3] The coating liquid for organic electroluminescence device according to [1] or [2], wherein the first solvent is an amide based solvent.
[4] The coating liquid for organic electroluminescence device according to any one of [1] to [3], which further comprises a polyhydric alcohol as a third solvent.
[5] The coating liquid for organic electroluminescence device according to [4], wherein the polyhydric alcohol is at least one member selected from ethylene glycol, diethylene glycol and glycerin.
[6] The coating liquid for organic electroluminescence device according to [4] or [5], wherein a content of the third solvent is from 5 % by mass to 40 % by mass relative to a total amount of the coating liquid.
[7] A method for manufacturing an organic electroluminescence device, which comprises:
   a step of forming a first electrode on a substrate;
   a step of coating a coating liquid for organic electroluminescence device described in any one of [1] to [6] on the substrate having the first electrode formed thereon, to form an organic layer; and
   a step of forming a second electrode on the organic layer.
[8] An organic electroluminescence device comprising an organic layer between a pair of electrodes, wherein at least one organic layer is formed from a coating liquid for organic electroluminescence device described in any one of [1] to [6].
[9] An organic electroluminescence device comprising an organic layer between a pair of electrodes, wherein the organic electroluminescence device is manufactured by a method for manufacturing an organic electroluminescence device described in [7].

### EFFECT OF THE INVENTION

According to the invention, a problem to be solved by the invention is to solve the foregoing conventional problems and achieve the following objects.

According to the invention, it is possible to provide a coating liquid for organic electroluminescence device capable of fabricating an organic electroluminescence device with satisfactory durability and excellent efficiency.

Also, according to the invention, it is possible to provide a method for manufacturing an organic electroluminescence device with satisfactory durability and excellent efficiency.

Furthermore, according to the invention, it is possible to provide an organic electroluminescence device with satisfactory durability and excellent efficiency.

### BRIEF DESCRIPTION OF DRAWING

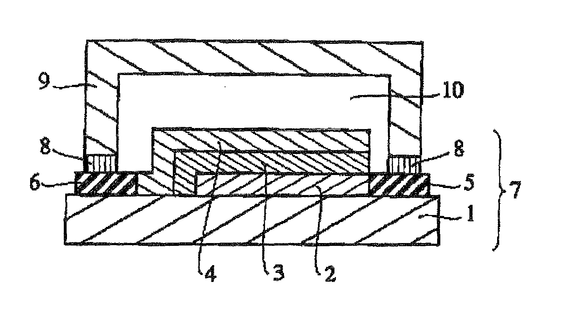

Fig. 1 is a diagrammatic sectional view showing one embodiment of a light emitting device of the invention.

### MODES FOR CARRYING OUT THE INVENTION

The invention is hereunder described in detail. Incidentally, in this description, a numerical range expressed by the terms "a number to another number" means a range falling between the former number indicating minimum value of the range and the latter number indicating a maximum value thereof.

### <Coating liquid for organic electroluminescence device>

The coating liquid for organic electroluminescence device of the invention (hereinafter properly referred to as a "coating liquid for organic EL device") is a coating liquid for organic electroluminescence device for forming an organic layer between a pair of electrodes, which includes a first solvent and a second solvent, in which the first solvent is at least one member selected from solvents capable of dissolving a light emitting material and a host material contained in a light emitting layer and having a boiling point of 200°C or higher; the second solvent is at least one member selected from solvents having an azeotropic temperature with water of 99°C or less; and a relation between a boiling point (BP1) of the first solvent and a boiling point (BP2) of the second solvent is BP1 ≥ BP2.

Each of components constituting the coating liquid for organic EL device of the invention is hereunder described.

### [Solvents]

### (First solvent)

The coating liquid for organic EL device of the invention contains, as a first solvent, at least one member selected from solvents capable of dissolving a light emitting material and a host material contained in a light emitting layer and having a boiling point of 200°C or higher. The boiling point of the first solvent is preferably from 200 to 300°C, and more preferably from 200 to 250°C.

According to this, an enhancement of smoothness of a light emitting layer coating film and an enhancement of adhesion to an adjoining layer are obtained, and it becomes possible to enhance light emission efficiency of the organic EL device and durability of the device.

Examples of such a first solvent include amide based solvents, aprotic polar solvents other than amide based solvents, and high-boiling hydrophobic solvents.

Examples of the amide based solvents include N-methyl-2-pyrrolidone (boiling point: 202°C), 2-pyrrolidone (boiling point: 245°C), 1-acetyl-2-pyrrolidone (boiling point: 231°C), N-ethyl-2-pyrrolidone (boiling point: 218°C), 1,3-dimethyl-2-imidazolidinone (boiling point: 220°C), formamide (boiling point: 210.5°C), N,N-dibutylformamide (boiling point: 243°C), m-xylylenediamine (boiling point: 245°C), and so on, or derivatives thereof.

Examples of the aprotic polar solvents other than amide based solvents include propylene carbonate (boiling point: 243°C), γ-butyrolactone (boiling point: 204°C), γ-valerolactone (boiling point: 207°C), α-acetyl-γ-butyrolactone (boiling point: 235°C), and so on, or derivatives thereof.

Examples of the high-boiling hydrophobic solvents include cyclohexylbenzene (boiling point: 240°C), 1,2,3,4-tetramethylbenzene (boiling point: 203°C), 3-methylbiphenyl (boiling point: 272°C), 4-methylbiphenyl (boiling point: 262°C), 1-methylnaphthalene (boiling point: 244.8°C), and so on, or derivatives thereof.

From the viewpoint of solubility of the light emitting material, amide based solvents are preferable. Above all, N-methyl-2-pyrrolidone, N-ethyl-2-pyrrolidone or 1,3-dinlethyl-2-imidazolidinone is preferable, with N-methyl-pyrrolidone or 1,3-dimethyl-2-imidazolidinone being more preferable.

The first solvent may be a mixture of two or more kinds thereof.

### (Second solvent)

The coating liquid for organic EL device of the invention contains, as a second solvent, at least one member selected from solvents having an azeotropic temperature with water of not higher than 99°C. The azeotropic temperature with water is preferably from 98 to 50°C, and preferably from 80 to 50°C.

According to this, moisture in the film-formed organic layer can be removed, thereby enabling it possible to make a life of the organic electroluminescence device long.

Examples of such a second solvent include ethanol, 1-propanol, 2-propanol, 1-butanol, 2-butanol, 2-n-butoxyethanol, propylene glycol monomethyl ether acetate, methyl ethyl ketone, hexane, toluene, cumene, ethyl acetate, butyl acetate, isobutyl acetate, propyl acetate, isopropyl acetate, and so on.

The second solvent may be a mixture of two or more kinds thereof.

As a preferred combination of the first solvent and the second solvent, it is preferable to use a solvent selected from amide based solvents as the first solvent and a solvent selected from alcohol based solvents as the second solvent. Also, it is more preferable to use a solvent selected from N-methyl-2-pyrrolidone and 1,3-dimethyl-2-imidazolidinone as the first solvent and a solvent selected from 2-n-butoxyethanol and propylene glycol monomethyl ether acetate as the second solvent.

A mass ratio of use amounts of the first solvent and the second solvent is preferably from 50:50 to 95:5, and more preferably from 60:40 to 90:10. This is because when the mass ratio falls within this range, solubility of the light emitting material and the host material can be kept, and film formation of an organic film in which the light emitting material is uniformly dispersed in the host material can be achieved without causing deposition and phase separation.

### (Third solvent)

It is preferable that the coating liquid further contains a polyhydric alcohol as a third solvent. According to this, a dissolved oxygen concentration in the coating liquid can be reduced. Examples of such a third solvent include polyhydric alcohols such as glycerin, ethylene glycol, diethylene glycol, triethylene glycol, tetraethylene glycol, and so on. The third solvent may be a mixture of two or more kinds thereof. The polyhydric alcohol is preferably at least one member selected from ethylene glycol, diethylene glycol and glycerin, with ethylene glycol or diethylene glycol being more preferable.

An addition amount of the third solvent is preferably from 5 % by mass to 40 % by mass, more preferably from 5 to 20 % by mass, and still more preferably from 5 to 10 % by mass relative to a total amount of the coating liquid.

Incidentally, each of the first solvent, the second solvent and the third solvent is preferably one having been subjected to a purification treatment. Specifically, there can be adopted an arbitrary method such as (1) a column purification treatment with a silica gel, alumina, a cationic ion exchange resin, an anionic ion exchange resin, etc.; (2) a dehydration treatment with anhydrous sodium sulfate, anhydrous calcium sulfate, magnesium sulfate, strontium sulfate, barium sulfate, barium oxide, calcium oxide, magnesium oxide, molecular sieves, zeolite, etc.; (3) a distillation treatment; (4) a bubbling treatment with an inert gas (e.g., nitrogen or argon), etc.; (5) a removal treatment of impurities by means of filtration, centrifugal sedimentation, etc.; and the like. A purification treatment by means of a column purification treatment or a dehydration treatment is more preferable.

Examples of the organic layer which can be formed by applying the coating liquid for organic EL device of the invention include a light emitting layer, a hole transport layer, a hole injection layer, a charge transport layer, a charge injection layer, and so on. The coating liquid for organic EL device may be applied to any one of layers, or may be applied in plural layers. The coating liquid for organic EL device is preferably applied to the light emitting layer or the hole transport layer or both layers of the light emitting layer and the hole transport layer, and it is more preferably applied to the light emitting layer.

Examples of components of the coating liquid for organic EL device include materials contained in the light emitting layer, the hole transport layer, the hole injection layer, the charge transport layer, the charge injection layer, or the like.

### [Other components]

To the coating liquid for organic EL device, other additives and coating film stabilizing materials may be added. For example, a stabilizer, a viscosity modifier, an aging inhibitor, a pH modifier, an antiseptic, a resin emulsion, a leveling agent, or the like can be used.

A viscosity of the coating liquid for organic EL device of the invention is preferably from 1 mPa·s to 50 mPa·s, and more preferably from 2 mPa·s to 10 mPa·s.

Also, a surface tension of the coating liquid for organic EL device of the invention is from 20 mN/m to 70 mN/m, and preferably from 25 mN/m to 40 mN/m. By allowing the surface tension to fall within this range, it is possible to form a smooth coating film which is free from cissing or unevenness.

Also, although it is preferable that the coating liquid for organic EL device of the invention satisfies the foregoing numerical value range regarding at least one of the viscosity and the surface tension, the coating liquid for organic EL device of the invention may be one satisfying the condition regarding an arbitrary combination of two or more characteristics and may be further one satisfying all of the characteristics. According to this, it is possible to present a composition suited for coating.

### [Manufacturing method of organic electroluminescence device]

Next, a manufacturing method of the organic electroluminescence device of the invention is described.

The manufacturing method of the organic electroluminescence device of the invention includes:
a step of forming a first electrode on a substrate;
a step of coating the coating liquid for organic electroluminescence device of the invention on the substrate having the first electrode formed thereon, to form an organic layer; and
a step of forming a second electrode on the organic layer.

In the manufacturing method of the organic EL device of the invention, by using the coating liquid for organic EL device of the invention containing the first solvent and the second solvent, it is possible to manufacture an organic electroluminescence device with satisfactory durability and excellent light emission efficiency. It may be considered that this is because not only a lowering of the film quality to be caused due to deposition of materials of the formed organic layer during drying can be prevented from occurring, but moisture can be sufficiently removed.

In the case where plural organic layers are present, the step of forming at least one organic layer may be a step of coating the coating liquid for organic electroluminescence device of the invention to form an organic layer, and the step of forming other organic layer(s) may be achieved by means of film formation by a dry film forming method or a wet film forming method. Adoption of a wet film forming method is preferable because a large area of the organic layer can be easily realized, and a light emitting device with high luminance and excellent light emission efficiency is efficiently obtainable at low costs. A vapor deposition method, a sputtering method or the like can be adopted as the dry film forming method, and a printing method or a coating method can be adopted as the wet film forming method.

The first electrode may be a back electrode as described later, and as to the forming step of the first electrode, a description regarding a forming method of a back electrode can be applied.

The second electrode may be a transparent electrode as described later, and as to the forming step of the second electrode, a description regarding a forming method of a transparent electrode can be applied.

As a coating method in the step of coating the coating liquid for organic electroluminescence device of the invention on the substrate having the first electrode formed thereon to thereby form an organic layer, a spin coating method, a dip coating method, a casting method, a die coating method, a roll coating method, a bar coating method, a gravure coating method, a spray coating method, an inkjet method, or the like can be adopted. Such a film forming method can be properly selected according to the material of the organic layer. Above all, a dip coating method, a spray coating method or an inkjet method is preferable because such a method is a method with high use efficiency of the coating liquid (with a few loss).

Also, it is preferable to achieve drying after the film formation. Drying is carried out by selecting a condition of temperature, pressure or the like in such a manner that the coating layer is not damaged. Also, at the time of drying, for the purposes of (1) preventing a lowering of light emission efficiency of the organic electroluminescence device following addition of oxygen to the organic film from occurring and (2) preventing a lowering of durability of the organic electroluminescence device following moisture absorption of the organic film from occurring, it is preferable to carry out drying in an atmosphere of an inert gas with a low dew point (e.g., nitrogen, argon, etc.).

### [Organic electroluminescence device]

The organic electroluminescence device which is used in the invention is hereunder described.

The organic electroluminescence device of the invention is an organic electroluminescence device including an organic layer between a pair of electrodes, wherein at least one of the organic layers is formed from a coating liquid for organic electroluminescence device of the invention.

It is preferable that the organic layer includes a light emitting layer; and that the light emitting layer contains a phosphorescent light emitting compound. If desired, an organic layer other than the light emitting layer, a protective layer, a sealing layer or the like may be provided.

It is preferable that the organic electroluminescence device is fabricated by the manufacturing method of the invention.

It is preferable that an oxygen concentration in the device is as low as possible. The oxygen concentration is sufficiently 100 ppm or less, and preferably 50 ppm or less. A method of obtaining an atmosphere where the oxygen concentration is 100 ppm or less is not particularly limited. For example, a sealing step may be carried out in an inert gas atmosphere where the oxygen concentration is 100 ppm or less. From the viewpoint of easiness of handling, the inert gas is preferably nitrogen, argon or the like.

Fig. 1 is a diagrammatic sectional view showing one embodiment of the light emitting device of the invention. The light emitting device shown in Fig. 1 includes a light emitting layered product 7 having a transparent electrode 2, an organic layer 3 and a back electrode 4 stacked on a base material 1; and a sealing member 9 for sealing the organic layer 3. In such an embodiment, the sealing member 9 is allowed to adhere to the base material 1, a transparent electrode lead 5, a back electrode lead 6 and the like by a sealing agent (adhesive) 8 and placed on the light emitting layered product 7. A moisture absorbent or an inactive liquid may be inserted in a space 10. The moisture absorbent is not particularly limited, and specific examples thereof include barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, magnesium oxide, and so on. Paraffins, liquid paraffins, fluorine based solvents (e.g., perfluoroalkanes, perfluoroamines, perfluoroethers, etc.), chlorine based solvents, silicone oils, and so on can be used as the inactive liquid.

In the light emitting device of the invention, the constitution of the light emitting layered product may be a constitution in which transparent electrode/light emitting layer/back electrode, transparent electrode/light emitting layer/electron transport layer/back electrode, transparent electrode/hole transport layer/light emitting layer/electron transport layer/back electrode, transparent electrode/hole transport layer/light emitting layer/back electrode, transparent electrode/light emitting layer/electron transport layer/electron injection layer/back electrode, transparent electrode/hole injection layer/hole transport layer/light emitting layer/electron transport layer/electron injection layer/back electrode, or the like are stacked successively or conversely on a base material, or the like. The light emitting layer contains a phosphorescent light emitting compound, and in general, light emission is extracted from the transparent electrode. Specific examples of compounds which are used in the respective layers are described in, for example, an extra issue "Organic EL Display" of Monthly Display, October, 1998 (Techno Times Co., Ltd.) and the like.

A position at which the organic layer is formed is not particularly limited and can be properly selected according to the application and purpose of the light emitting device. However, it is preferable that the organic layer is formed on the transparent electrode or back electrode. At that time, the organic layer may be formed on the entire surface or a part of the transparent electrode or back electrode. The shape, size and thickness of the organic layer can also be properly selected according to the purpose.

Although any one of the organic layers is film-formed by a wet film forming method using the coating liquid of the invention, other layer(s) may be film-formed by properly selecting a dry film forming method or a wet film forming method. Adoption of a wet film forming method is preferable because a large area of the organic layer can be easily realized, and a light emitting device with high luminance and excellent light emission efficiency is efficiently obtainable at low costs. A vapor deposition method, a sputtering method or the like can be adopted as the dry film forming method; and a dipping method, a spin coating method, a dip coating method, a casting method, a die coating method, a roll coating method, a bar coating method, a gravure coating method, a spray coating method, an inkjet method, or the like can be adopted as the wet film forming method. Such a film forming method can be properly selected according to the material of the organic layer. In the case of achieving the film formation by means of a wet film forming method, drying may be carried out after the film formation. Drying is carried out by selecting a condition of temperature, pressure or the like in such a manner that the coating layer is not damaged.

In general, when a direct current voltage (alternating current components may be contained) of from about 2 to 40 volts or a direct current is impressed between the transparent electrode and the back electrode, the light emitting device of the invention emits light. Also, in driving the light emitting device of the invention, driving methods described in JP-A-2-148687, JP-A-6-301355, JP-A-5-29080, JP-A-7-134558, JP-A-8-234685, JP-A-8-241047, U.S. Patents Nos. 5,828,429 and 6,023,308, Japanese Patent No. 2784615, and so on can be utilized. Although each of the layers constituting the light emitting layered product which is used in the invention is hereunder described in detail, it should not be construed that the invention is limited thereto.

### (A) Base material:

It is preferable that the base material which is used in the invention is made of a material which is impermeable to moisture, or a material which is extremely low in moisture permeability. It is preferable that the material does not scatter or attenuate light emitted from the organic layer. Specific examples thereof include inorganic materials such as zirconia-stabilized yttrium (YSZ), glass, and the like; organic materials such as polyesters, for example, polyethylene terephthalate, polybutylene terephthalate, polyethylene naphthalate, etc., polystyrene, polycarbonate, polyethersulfones, polyarylates, allyl diglycol carbonate, polyimides, polycycloolefins, norbornene resins, poly(chlorotrifluoroethylene), and the like; and so on. Above all, organic materials not only having excellent heat resistance, dimensional stability, solvent resistance, electric insulating properties and processability but having low gas permeability and low hygroscopicity can be especially preferably used. The base material may be formed of a single material or may be formed of two or more kinds of materials. The material of the base material may be properly selected according to the material of the transparent electrode. For example, in the case where the transparent electrode is made of indium tin oxide (ITO), it is preferable to use a material having a small difference in lattice constant from ITO.

The shape, structure, size and the like of the base material can be properly selected according to the application and purpose of the light emitting device. As to the shape, a plate-shaped material is generally used. The structure may be a single-layer structure, or it may be a layered structure. Although the base material may be either colorless transparent or colored transparent, it is preferable that the base material is colorless transparent from the viewpoint that it does not scatter or attenuate light emitted from the light emitting layer.

A moisture permeation preventive layer (a gas barrier layer) may be provided on a surface of the base material on the electrode side, on a surface of the base material on the side opposite to the electrode, or on both of these two surfaces. As a material constituting the moisture permeation preventive layer, it is preferable to use an inorganic material such as silicon nitride, silicon oxide and the like. The moisture permeation preventive layer can be film-formed by means of a high-frequency sputtering method or the like. Also, if desired, a hard coat layer or an undercoat layer may be provided on the base material.

### (B) Transparent electrode:

In general, the transparent electrode has a function as an anode which supplies a hole to the organic layer. However, the transparent electrode can also be allowed to function as a cathode, and in that case, the back electrode is allowed to function as an anode. The case where the transparent electrode is allowed to work as an anode is hereunder described.

The shape, structure, size and the like of the transparent electrode are not particularly limited and can be properly selected according to the application and purpose of the light emitting device. As a material for forming the transparent electrode, metals, alloys, metal oxides, electrically conductive compounds and mixtures thereof, and so on can be used. Materials having a work function of 4 eV or more are preferably used. Specific examples thereof include antimony-doped tin oxide (ATO), fluorine-doped tin oxide (FTO), semiconductor metal oxides (e.g., tin oxide, zinc oxide, indium oxide, indium tin oxide (ITO), indium zinc oxide (IZO), etc.), metals (e.g., gold, silver, chromium, nickel, etc.), mixtures or layered products of such a metal and an electrically conductive metal oxide, inorganic electrically conductive substances (e.g., copper iodide, copper sulfide, etc.), organic electrically conductive materials (e.g., polyaniline, polythiophene, polypyrrole, etc.) and layered products thereof with ITO, and so on.

The transparent electrode can be formed on the base material by means of a wet method such as a printing method, a coating method, and the like; a physical method such as a vacuum vapor deposition method, a sputtering method, an ion plating method, and the like; a chemical method such as CVD, a plasma CVD method, and the like; or the like. The forming method may be properly selected taking into consideration adaptability to the transparent electrode material. For example, in the case where ITO is used as the material of the transparent electrode, a direct current or high-frequency sputtering method, a vacuum vapor deposition method, an ion plating method, or the like may be adopted. Also, in the case where an organic electrically conductive material is used as the material of the transparent electrode, a wet film forming method may be adopted.

Patterning of the transparent electrode can be carried out by means of chemical etching by photolithography or the like, physical etching using a laser or the like, or the like. Also, the patterning may be carried out by vacuum vapor deposition or sputtering using a mask, a lift-off method, a printing method, or the like.

Although a position at which the transparent electrode is formed may be properly selected according to the application and purpose of the light emitting device, it is preferable to form the transparent electrode on the base material. At that time, the transparent electrode may be formed on the whole or only a part of the surface of the base material.

Although a thickness of the transparent electrode may be properly selected according to the material thereof, it is in general from 10 nm to 50 µm, and preferably from 50 nm to 20 µm. A resistance value of the transparent electrode is preferably not more than 10² Ω/square, and more preferably not more than 10 Ω/square. The transparent electrode may be either colorless transparent or colored transparent. In order to extract light emission from the transparent electrode side, its permeability is regulated to preferably 60 % or more, and more preferably 70 % or more. The permeability can be measured in conformity with a known method using a spectrophotometer.

Also, electrodes described in detail in TOUMEI DODENMAKU NO SHINTENKAI (Novel Developments in Transparent Electrically Conductive Films) (edited by SAWADA, Yutaka, published by C.M.C. in 1999) or the like can be applied to the invention. In particular, in the case where a plastic base material with low heat resistance is used, it is preferable to use ITO or IZO as the transparent electrode material and to perform film formation at a low temperature of not higher than 150°C.

### (C) Back electrode:

In general, although the back electrode has a function as a cathode for injecting an electron into the organic layer, it can also be allowed to function as an anode. In that case, the transparent electrode is allowed to function as a cathode. The case where the back electrode is allowed to work as a cathode is hereunder described.

The shape, structure, size and the like of the back electrode are not particularly limited and can be properly selected according to the application and purpose of the light emitting device. As a material for forming the back electrode, metals, alloys, metal oxides, electrically conductive compounds and mixtures thereof, and so on can be used. Materials having a work function of not more than 4.5 eV are preferably used. Specific examples thereof include alkali metals (e.g., Li, Na, K, Cs, etc.), alkaline earth metals (e.g., Mg, Ca, etc.), gold, silver, lead, aluminum, a sodium-potassium alloy, a lithium-aluminum alloy, a magnesium-silver alloy, indium, rare earth metals (e.g., ytterbium, etc.), and so on. Although such a material may be used solely, it is preferable to jointly use two or more kinds thereof for the purpose of making both stability and electron injection properties compatible with each other. Of these materials, alkali metals and alkaline earth metals are preferable from the viewpoint of electron injection properties, and materials mainly including aluminum are preferable from the viewpoint of storage stability. The material mainly including aluminum as referred to herein means aluminum solely, an alloy or mixture of aluminum and from 0.01 to 10 % by mass of an alkali metal or an alkaline earth metal (e.g., a lithium-aluminum alloy, a magnesium-aluminum alloy, etc.). As the material of the back electrode, those described in detail in JP-A-2-15595, JP-A-5-121172, and so on can be used.

The back electrode can be formed by means of a wet method such as a printing method, a coating method, and the like; a physical method such as a vacuum vapor deposition method, a sputtering method, an ion plating method, and the like; a chemical method such as CVD, a plasma CVD method, and the like; or the like. The forming method may be properly selected taking into consideration adaptability to the back electrode material. For example, in the case of using two or more kinds of metals, or the like as the material of the back electrode, the back electrode can be formed by sputtering those materials simultaneously or successively.

Patterning of the back electrode can be carried out by means of chemical etching by photolithography or the like, physical etching using a laser or the like, or the like. Also, the patterning may be carried out by vacuum vapor deposition or sputtering using a mask, a lift-off method, a printing method, or the like.

Although a position at which the back electrode is formed may be properly selected according to the application and purpose of the light emitting device, it is preferable to form the back electrode on the organic layer. At that time, the back electrode may be formed on the whole or only a part of the surface of the organic layer. Also, a dielectric layer including a fluoride of an alkali metal or an alkaline earth metal, or the like may be disposed in a thickness of from 0.1 to 5 nm between the back electrode and the organic layer. The dielectric layer can be formed by means of a vacuum vapor deposition method, a sputtering method, an ion plating method, or the like.

Although a thickness of the back electrode may be properly selected according to the material thereof, it is in general from 10 nm to 5 µm, and preferably from 50 nm to 1 µm. The back electrode may be either transparent or opaque. The transparent back electrode may be formed by subjecting a layer of the foregoing materials to film formation thin in a thickness of from 1 to 10 nm and further laminating a transparent electrically conductive material such as ITO, IZO and the like thereon.

### (D) Light emitting layer:

In the light emitting device of the invention, it is preferable that the light emitting layer contains a phosphorescence light emitting compound. The phosphorescent light emitting compound which is used in the invention is not particularly limited so far as it is a compound capable of emitting light from a triplet exciton. As the phosphorescent light emitting compound, it is preferable to use an ortho-metalated complex or a porphyrin complex, and it is more preferable to use an ortho-metalated complex. Of the porphyrin complexes, a porphyrin platinum complex is preferable. The phosphorescent light emitting compound may be used solely or in combination of two or more of kinds thereof.

The ortho-metalated complex as referred to in the invention is a generic name of a group of compounds described in YAMAMOTO, Akio, Organometallic Chemistry - Principles and Applications, pages 150 and 232, Shokabo Publishing Co., Ltd. (1982); H. Yersin, Photochemistry and Photophysics of Coordination Compounds, pages 71 to 77 and 135 to 146, Springer-Verlag (1987); and the like. Although a ligand for forming the ortho-metalated compound is not particularly limited, it is preferably a 2-phenylpyridine derivative, a 7,8-benzoquinoline derivative, a 2-(2-thienyl)pyridine derivative, a 2-(1-naphthyl)pyridine derivative or a 2-phenylquinoline derivative. Such a derivative may have a substituent. Also, the derivative may have other ligand than the ligand which is essential for forming such an ortho-metalated complex. As a central metal for forming the ortho-metalated complex, any metal can be used so far as it is a transition metal. In the invention, rhodium, platinum, gold, iridium, ruthenium, palladium, or the like can be preferably used. Above all, indium is especially preferable. The organic layer containing such an ortho-metalated complex has excellent light emission luminance and light emission efficiency.

Specific examples of the light emitting material of the invention include those described in US6303238B1, US6097147, WO00/57676, WO00/70655, WO01/08230, WO01/39234A2, WO01/41512A1, WO02/02714A2, WO02/15645A1, WO02/44189A1, JP-A-2001-247859, Japanese Patent Application No. 2000-33561, JP-A-2002-117978, JP-A-2002-225352, JP-A-2002-235076, Japanese Patent Application No. 2001-239281, JP-A-2002-170684, EP1211257, JP-A-2002-226495, JP-A-2002-234894, JP-A-2001-247859, JP-A-2001-298470, JP-A-2002-173674, JP-A-2002-203678, JP-A-2002-203679, JP-A-2004-111379, JP-A-2004-357791, JP-A-2004-214179, JP-A-2005-120209, JP-A-2005-310733, JP-A-2006-256999, JP-A-2007-73891, JP-A-2007-81388, JP-A-2008-270737, JP-A-2008-19443, and so on.

The light emitting material of the invention may have a polymerizable group. Examples of the polymerizable group include acrylate, methacrylate, vinyl, vinyl ether, epoxy, oxetane, alkoxysilane, isocyanate and hydroxy groups, and so on.

Specifically, the following compounds are exemplified.

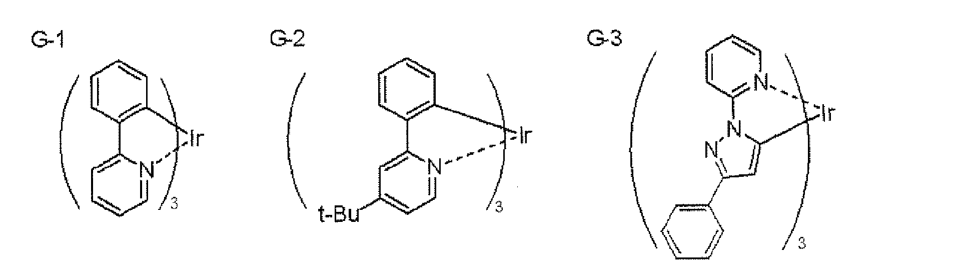

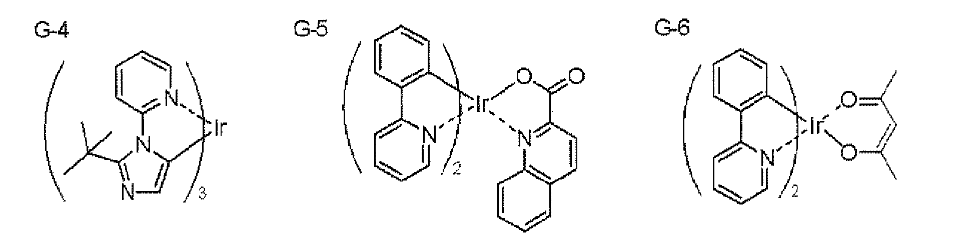

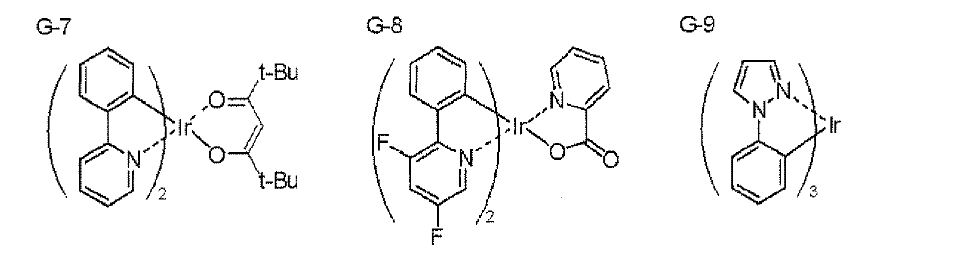

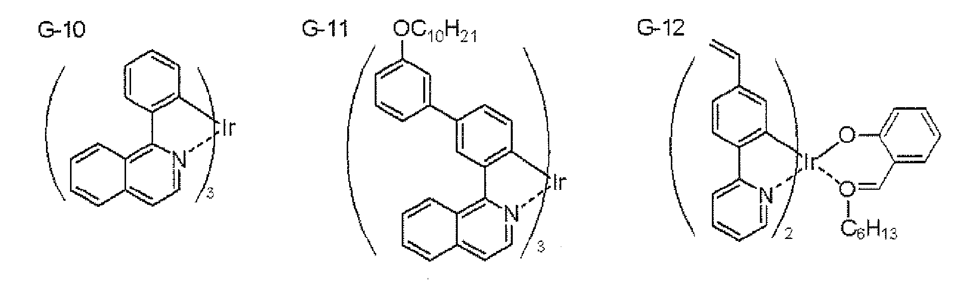

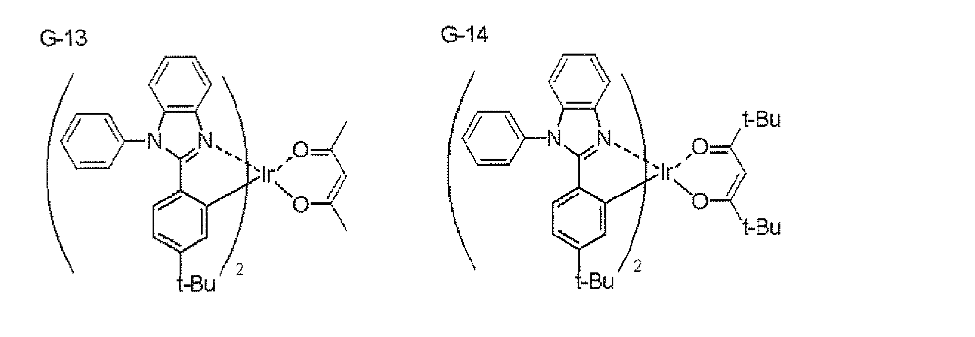

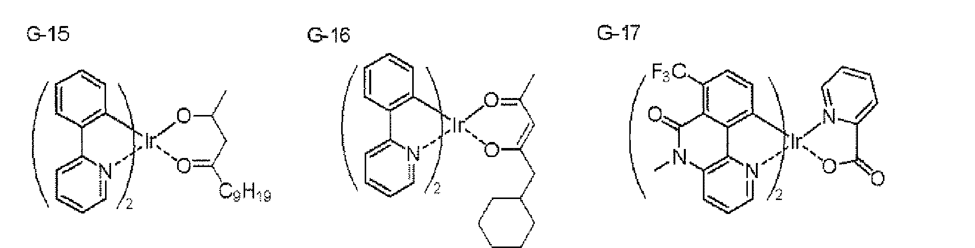

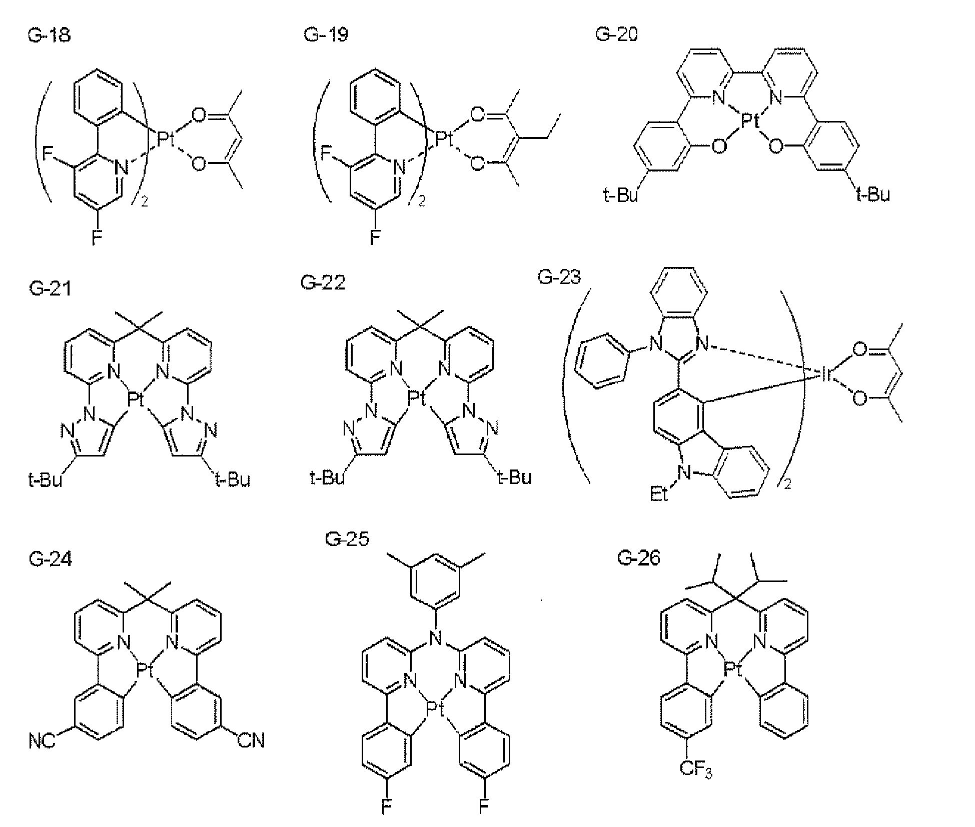

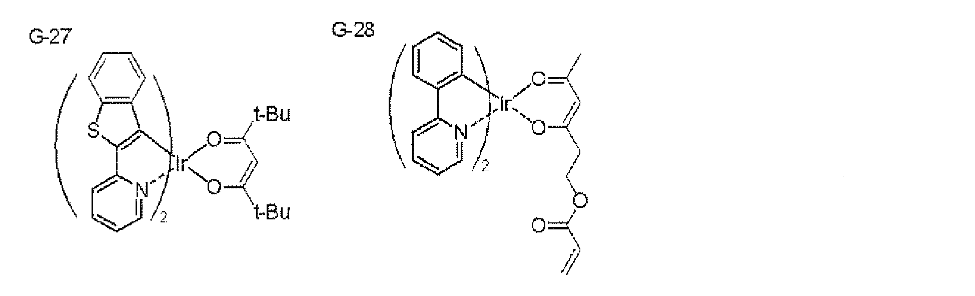

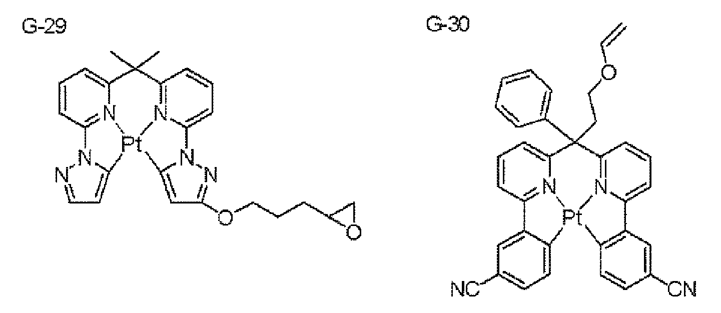

The ortho-metalated complex which is used in the invention can be synthesized according to known techniques such as those described in Inorg. Chem., 30, 1685, 1991; Inorg. Chem., 27, 3464, 1988; Inorg. Chem., 33, 545, 1994; Inorg Chim. Acta, 181, 245, 1991; J. Organomet. Chem., 335, 293, 1987; J. Am. Chem. Soc., 107, 1431, 1985; and so on.

Although a content of the phosphorescent light emitting compound in the light emitting layer is not particularly limited, it is, for example, from 0.1 to 70 % by mass, and preferably from 1 to 20 % by mass. When the content of the phosphorescent light emitting compound is 0.1 % by mass or more and 70 % by mass or less, the effect thereof can be sufficiently exhibited.

In the invention, the light emitting layer may contain a host compound, a hole transport material, an electron transport material, an electrically inactive polymer binder, or the like, if desired.

The host compound as referred to herein is a compound which causes energy transfer from an exited state thereof to the phosphorescent light emitting compound, resulting in causing light emission of the phosphorescent light emitting compound. Specific examples thereof include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidene compounds, porphyrin compounds, anthraquinodimethane derivatives, anthrone derivatives, diphenylquinone derivatives, thiopyrane dioxide derivatives, carbodiimide derivatives, fluorenylidenemethane derivatives, distyrylpyrazine derivatives, heterocyclic tetracarboxylic acid anhydrides such as naphthalene perillene and the like, phthalocyanine derivatives, metal complexes of 8-quinolinol derivatives, metal complexes having, as a ligand, metal phthalocyanine, benzoxazole, benzothiazole, or the like, polysilane compounds, poly(N-vinylcarbazale) derivatives, aniline copolymers, thiophene oligomers, electrically conductive polymers such as polythiophene and the like, polythiophene derivatives, polyphenylene derivatives, polyphenylene vinylene derivatives, polyfluorene derivatives, and so on. Specifically, for example, those described in JP-A-9-12548, JP-A-2000-286056, JP-A-2003-178884, JP-A-2003-192652, JP-A-2004-217557, JP-A-2008-252094 and JP-A-2009-114370 are exemplified. The host compound may be used solely or in combination of two or more kinds thereof.

The host compound which is used in the invention is preferably a carbazole derivative or an arylamine derivative.

The hole transport material is not particularly limited so far as it has any one of a function to inject a hole from an anode, a function to transport a hole, and a function to block an electron injected from a cathode, and it may be either a low molecular material or a polymer material. Specific examples thereof include carbazole derivatives, triazole derivatives, oxazole derivatives, oxadiazole derivatives, imidazole derivatives. polyarylalkane derivatives, pyrazoline derivatives, pyrazolone derivatives, phenylenediamine derivatives, arylamine derivatives, amino-substituted chalcone derivatives, styryianthracene derivatives, fluorenone derivatives, hydrazone derivatives, stilbene derivatives, silazane derivatives, aromatic tertiary amine compounds, styrylamine compounds, aromatic dimethylidene compounds, porphyrin compounds, polysilane compounds, poly(N-vinylcarbazole) derivatives, aniline copolymers, thiophene oligomers, electrically conductive polymers such as polythiophene and the like (for example, polyethylenedioxythiophene/polystyrene sulfonic acid or polyethylenedioxythiopbene/Nafion), polythiophene derivatives, polyphenylene derivatives, polyphenylene vinylene derivatives, polyfluorene derivatives, polytriarylamine derivatives, and so on. These may be used alone a two or more kinds thereof may be used. The hole transport material is preferably polythiophene or an electrically conductive polymer such as arylanaine derivatives and the like. Specifically, for example, those described in JP-A-11-292829, JP-A-2000-150169, JP-A-2002-25780, JP-A-2003-82035, JP-A-2004-303636, JP-A-2004-18787, JP-A-2004-199935, JP-A-2008-186872, and JP-A-2008-311367 are exemplified.

Examples of the host compound and the hole transport material include compounds represented by the following general formula (1).

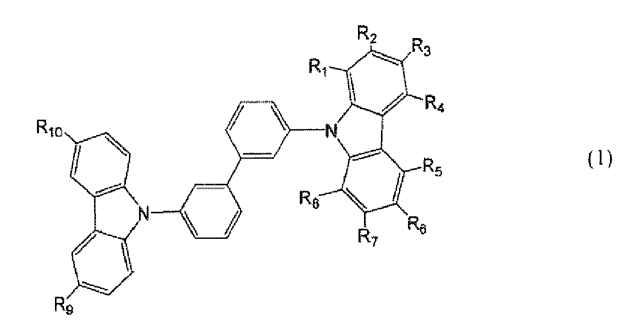

### (Each of R₁ to R₁₀ represents a hydrogen atom or a substituent.)

The substituent represented by R₁ to R₁₀ is preferably an alkyl group, a cycloalkyl group, an aryl group, an amino group, an alkoxy group, an aryloxy group, an acyl group, an alkoxycarbonyl group, an aryloxycarbonyl group, an acyloxy group, a sulfonylamino group, a sulfamoyl group, a carbamoyl group, an alkylthio group, an arylthio group, a heterocyclic thio group, a sulfonyl group, a sulfinyl group, a ureido group, a phosphoric acid amide group, a hydroxyl group, a mercapto group, a halogen atom, a sulfo group, a carboxyl group, a nitro group, a sulfino group, a heterocyclic group, or a silyl group; more preferably a substituted or unsubstituted alkyl group, a cycloalkyl group, an aryl group, an amino group, an alkoxy group, an aryloxy group, a cyano group, a fluorine atom, or a heterocyclic group; and still more preferably a methyl group, a trifluoromethyl group, a fluorine atom, a methoxy group, an aryl group, or a cyano group.

Each of R₁ to R₁₀ is especially preferably a hydrogen atom, a methyl group, an ethyl group, an isopropyl group, a tert-butyl group, an isopentyl group, a pentyl group, a hexyl group, a heptyl group, a trifluoromethyl group, a fluorine atom, a methoxy group, a phenyl group, or a 2-tolyl group; and most preferably a hydrogen atom, a methyl group, an ethyl group, a tert-butyl group, or a fluorine atom.

More specifically, the following compounds are exemplified as the compound represented by the general formula (1) and other host compound and the hole transport material. However, it should not be construed that the invention is limited thereto. Incidentally, n in the following compounds represents a number of repeating unfits.

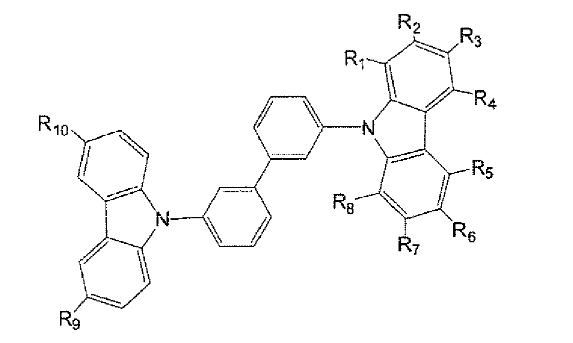

| Sample No. | R₁ | R₂ | R₃ | R₄ | R₅ | R₆ | R₇ | R₈ | R₉ | R₁₀ |
|---|---|---|---|---|---|---|---|---|---|---|
| H-1 | H | H | H | H | H | H | H | H | H | H |
| H-2 | H | Me | H | H | H | H | H | H | H | H |
| H-3 | H | H | t-Bu | H | H | H | H | H | H | H |
| H-4 | Cl | H | H | H | H | H | H | H | H | H |
| H-5 | H | H | t-Bu | H | H | t-Bu | H | H | t-Bu | t-Bu |
| H-6 | H | H | t-Bu | H | H | t-Bu | H | H | t-Bu | H |
| H-7 | H | H | t-Bu | H | H | H | H | H | t-Bu | H |
| H-8 | H | H | t-Bu | H | H | t-Bu | H | H | H | H |
| H-9 | H | H | H | Me | H | H | H | H | H | H |
| H-10 | H | Me | Me | H | H | H | H | H | H | H |
| H-11 | H | H | OMe | H | H | H | H | H | H | H |
| H-12 | H | H | Ph | H | H | H | H | H | H | H |

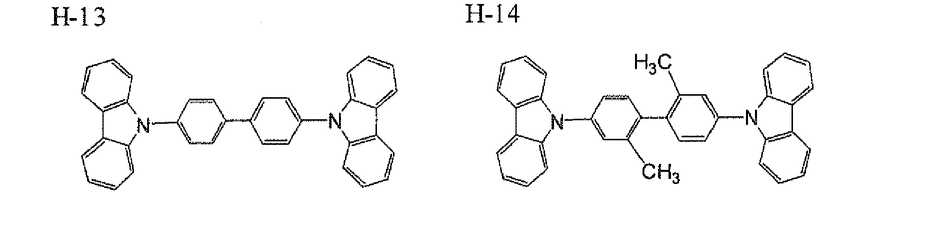

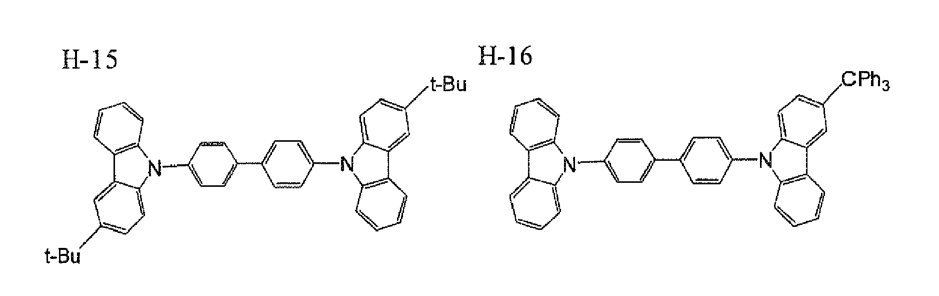

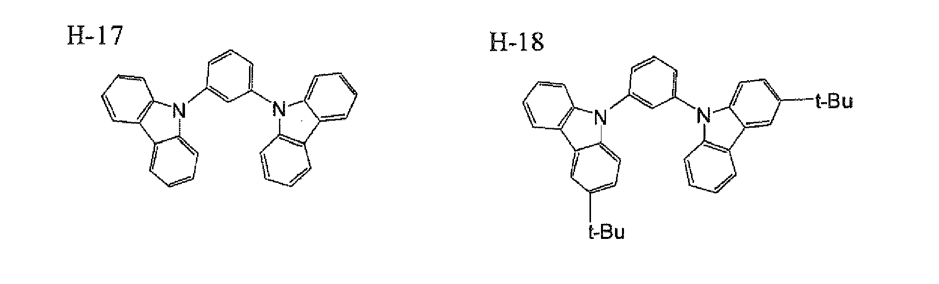

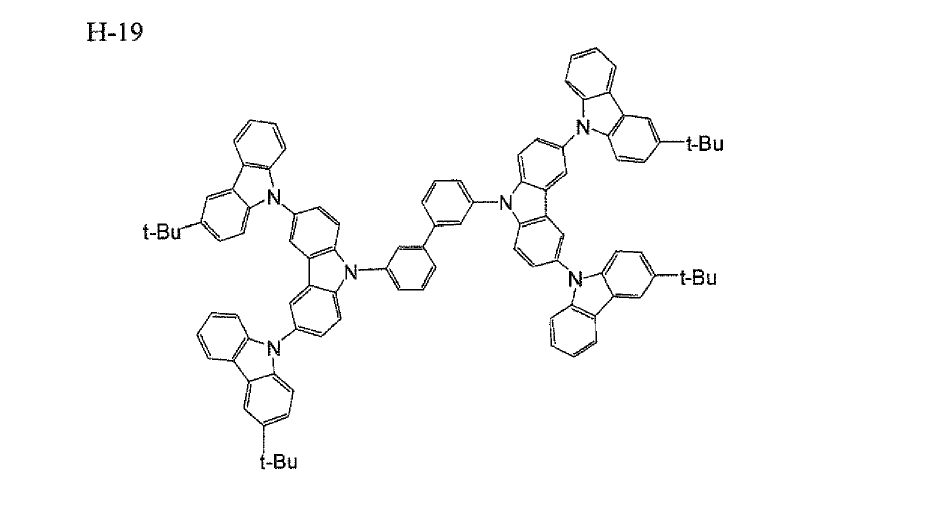

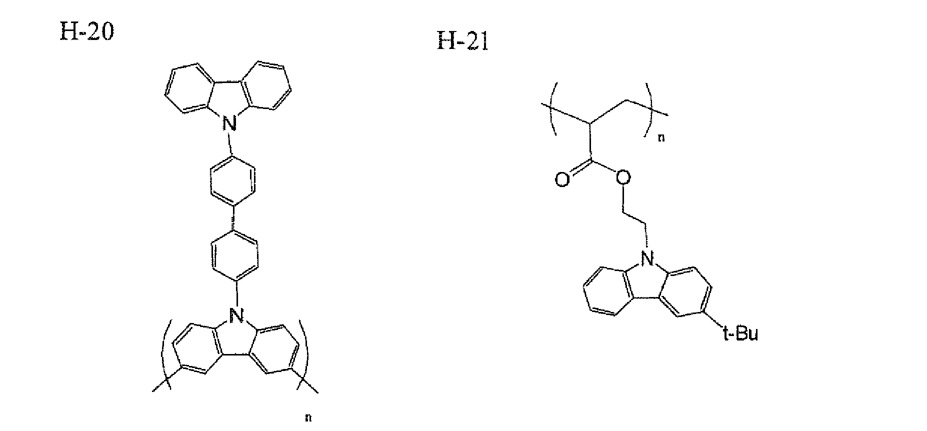

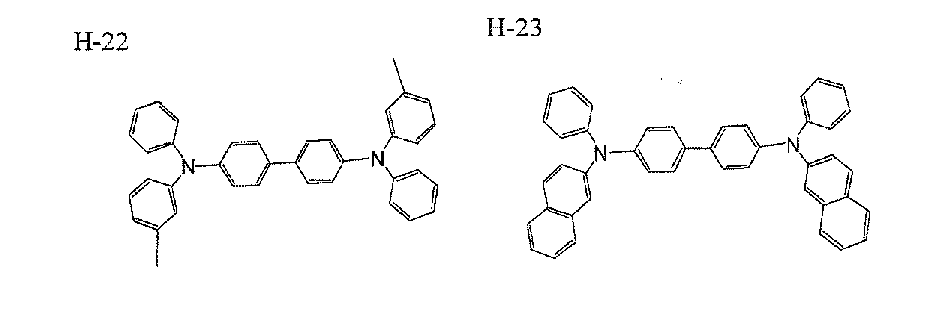

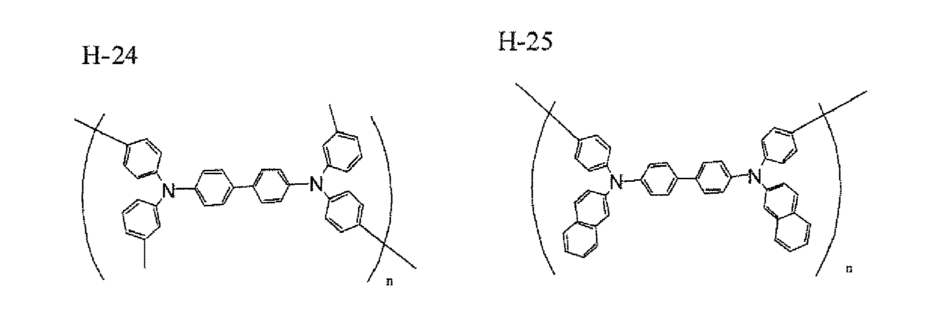

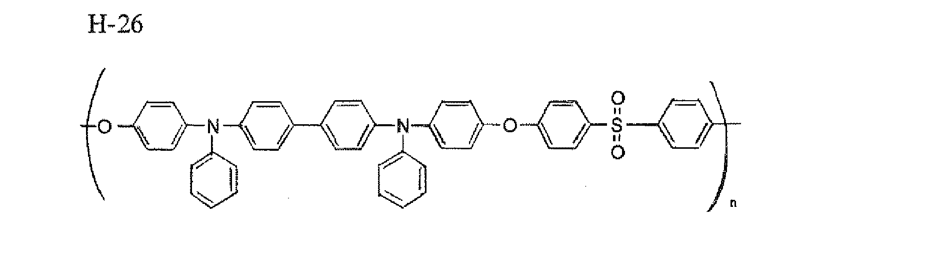

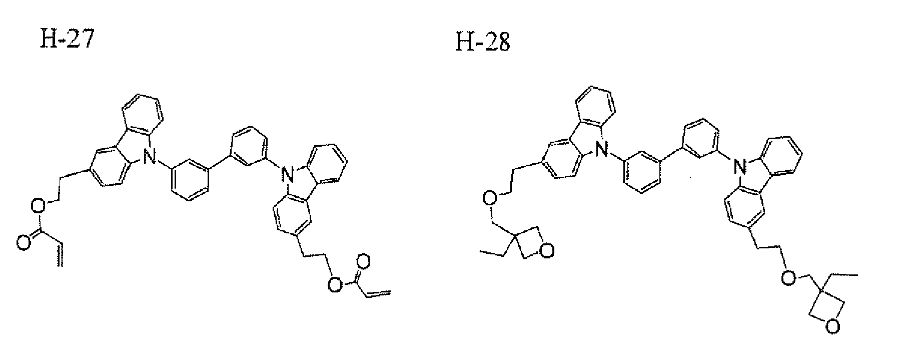

It is preferable that the hole injection layer contains a dopant working as a carrier for transfer of a hole. As the dopant to be introduced into the hole injection layer, either of an inorganic compound or an organic compound can be used so far as it is electron accepting and has properties of oxidizing an organic compound. Specifically, a Lewis acid compound such as ferric chloride, aluminum chloride, gallium chloride, indium chloride, antimony pentachloride, and the like can be suitably used as the inorganic compound.

In the case of an organic compound, a compound having, as a substituent, a nitro group, a halogen, a cyano group, a trifluoromethyl group, or the like; a quinone based compound; an acid anhydride baaed compound; a fullerene; and so on can be suitably used.

Specific examples thereof include hexacyanobutadiene, hexacyanobenzene, tetracyanoethylene, tetracyanoquinodimethane, tetrafluorotetracyanoquinodimethane, p-fluoranil, p-chloranil, p-bromanil, p-benzoquinone, 2,6-dichlorobenzoquinone, 2,5-dichlorobenzoquinone, tetramethylbenzoquinone, 1,2,4,3-tetracyanobenzene, o-dicyanobenzene, p-dicyanabenzene, 1,4-dicyanotetrafluorobenzene, 2,3-dichloro-5,6-dicyanobenzoquinone, p-dinitrobenzene, m-dinitrobenzene, o-dinitrobenzene, p-cyanonitrobenzene, m-cyanonitrobenzene, o-cyanonitrobenzene, 1,4-naphthoquinone, 2,3-dichloronaphthoquinone, 1-nitronaphthalene, 2-nitronaphthalene, 1,3-dinitronaphthalene, 1,5-dinitronaphthalene, 9-cyanoanthracene, 9-nitroanthracene, 9,10-anthraquinone, 1,3,6,8-tetranitrocarbazole, 2,4,7-trinitro-9-fluorenone, 2,3,5,6-tetracyanopyridine, maleic anhydride, phthalic anhydride, C60, C70, and so on.

Tetrafluorotetracyanoquinodimethane is preferable.

The electron transport material is not particularly limited so far as it has any one of a function to inject an electron from a cathode, a function to transport an electron, and a function to block a hole injected from an anode. For example, triazole derivatives, oxazole derivatives, oxadiazole derivatives, fluorenone derivatives, anthraquinodimethane derivatives, anthrone derivatives, diphenylquinone derivatives, thiopyrane dioxide derivatives, carbodiimide derivatives, fluorenylidenemethane derivatives, distyrylpyrazine derivatives, heterocyclic tetracarboxylic acid anhydrides such as naphthaleneperylene and the like, phthalocyanine derivatives, metal complexes of 8-quinolinol derivatives, metal complexes having, as a ligand, metallophthalocyanine, benzoxazole, benzothiazole, or the like, electrically conductive polymers such as aniline copolymers, thiophene oligomers, polythiophene, and the like, polythiophene derivatives, polyphenylene derivatives, polyphenylene vinylene derivatives, polyfluorene derivatives, pyrimidine derivatives, pyridine derivatives, carbazole derivatives, and so on can be used. Examples of the electron transport material include those described in JP-A-11-140060, JP-A-11-95265, JP-A-9-316441, JP-A-2002-10167, JP-A-2003-297391, JP-A-2007-258692, JP-A-2007-266598, and WO2007/080801.

As the polymer binder, polyvinyl chloride, polycarbonate, polystyrene, polymethyl methacrylate, polybutyl methacrylate, a polyester, polysulfone, polyphenylene oxide, polybutadiene, a hydrocarbon resin, a ketone resin, a phenoxy resin, a polyamide, ethyl cellulose, vinyl acetate, an ABS resin, polyurethane, a melamine resin, an unsaturated polyester compound, an alkyd resin, an epoxy resin, a silicone resin, polyvinyl butyral, polyvinyl acetal, and so on can be used. The light emitting layer containing a polymer binder can be easily formed in a large area upon coating by means of a wet film forming method.

A thickness of the light emitting layer is regulated to preferably from 10 to 200 nm, and more preferably from 20 to 80 nm. When the thickness is not more than 200 nm, an increase of the driving voltage can be inhibited, whereas when it is 10 nm or more, a short circuit of the light emitting device can be prevented from occurring.

### (E) Electron transport layer:

The light emitting device of the invention may have an electron transport layer including the foregoing electron transport material, if desired. The electron transport layer may contain the foregoing polymer binder. A thickness of the electron transport layer is preferably from 10 to 200 nm, and more preferably from 20 to 80 nm. When the thickness is not more than 200 nm, an increase of the driving voltage can be inhibited, whereas when it is 10 nm or more, a short circuit of the light emitting device can be prevented from occurring.

### (F) Hole injection layer and hole transport layer:

The light emitting device of the invention may have a hole injection layer or a hole transport layer containing the foregoing hole injection material or hole transport material, if desired. The hole injection layer and the hole transport layer may contain the foregoing polymer binder. A thickness of the hole injection layer or the hole transport layer is regulated to preferably from 10 to 200 nm, and more preferably from 20 to 80 nm. When the thickness is not more than 200 nm, an increase of the driving voltage can be inhibited, whereas when it is 10 nm or more, a short circuit of the light emitting device can be prevented from occurring.

### (G) Others:

The light emitting device of the invention may have a protective layer described in JP-A-7-85974, JP-A-7-192866, JP-A-8-22891, JP-A-10-275682, JP-A-10-106746, or the like. The protective layer is formed on the uppermost surface of the light emitting device. The uppermost surface as referred to herein means an outer surface of a back electrode in the case of stacking a base material, a transparent electrode, an organic layer and a back electrode in this order, whereas it means an outer surface of a transparent electrode in the case of stacking a base material, a back electrode, an organic layer and a transparent electrode in this order. The shape, size, thickness and the like of the protective layer are not particularly limited. A material constituting the protective layer is not particularly limited so far as it has a function to prevent penetration or permeation of a substance which may deteriorate the light emitting device, such as moisture, oxygen, and the like, into the device. Silicon oxide, silicon dioxide, germanium oxide, germanium dioxide, or the like can be used.

A method of forming the protective layer is not particularly limited, and for example, a vacuum vapor deposition method, a sputtering method, a reactive sputtering method, a molecular epitaxy method, a cluster-ion beam method, an ion plating method, a plasma polymerization method, a plasma CVD method, a laser CVD method, a thermal CVD method, a coating method, or the like can be adopted.

### [Sealing]

Also, it is preferable that a sealing layer for preventing penetration of moisture or oxygen is provided in the light emitting device. As a material for forming the sealing layer, copolymers of tetrafluoroethylene and at least one comonomer; fluorine-containing copolymers having a cyclic structure in a copolymers main chain thereof; polyethylene; polypropylene; polymethyl methacrylate; polyimides; polyurea; polytetrafluoroethylene; polychlorotrifluoroethylene; polydichlorodifluoroethylene; copolymers of chlorotrifluoroethylene or dichlorodifluoroethylene and other comonomer; water absorbing substances having a coefficient of water absorption of 1 % or more; moisture permeation preventive substances having a coefficient of water absorption of not more than 0.1 %; metals (e.g., In, Sn, Pb, Au, Cu, Ag, Al, Tl, Ni, etc.); metal oxides (e.g., MgO, SiO, Si0₂, Al₂0₃, GeO, NiO, CaO, BaO, Fe₂0₃, Y₂0₃, Ti0₂, etc.); metal fluorides (e.g., MgF₂, LiF, AlF₃, CaF₂, etc.); liquid fluorinated carbons (e.g., perfluoroalkanes, perfluoroamines, perfluoroethers, etc.); substances obtained by dispersing an adsorbing agent of moisture or oxygen in the liquid fluorinated carbon; and so on can be used.

According to the organic EL device of the invention, light emission can be obtained by impressing a direct current (alternating current components may be contained, if desired) voltage (usually from 2 volts to 15 volts) or a direct current between the anode and the cathode.

As to the driving method of the organic EL device of the invention, driving methods described in JP-A-2-148687, JP-A-6-301355, JP-A-5-29080, JP-A-7-134558, JP-A-8-234685, JP-A-8-241047, Japanese Patent No. 2784615, U.S. Patents Nos. 5,828,429 and 6,023,308, and so on can be applied.

### [Application]

The organic electroluminescence device fabricated according to the invention is able to impart high efficiency and device life, and therefore, it is suitably used for full-color displays, backlights, surface light sources such as illumination light sources and the like, light source arrays of printers or the like, and so on.

### EXAMPLES

The invention is more specifically described below with reference to the Examples. Materials, reagents, amounts of substances and ratios thereof, operations, and the like shown in the following Examples can be appropriately changed unless deviating from the gist of the invention. In consequence, it should be construed that the scope of the invention is not limited to the following specific examples.

### [Examples 1]

### (Preparation of coating liquid A)

0.15 % by mass of an iridium complex (Ir(ppy)₃), 2.85 % by mass of the following Compound (1) and 97 % by mass of a solvent (solvent obtained by mixing NMP (boiling point: 202°C) and 2-n-butoxyethanol (boiling point: 172°C; an azeotropic solvent; azeotropic temperature with water: 79.2°C) in a mass ratio of 60/40) were mixed to obtain a coating liquid for organic electroluminescence device (coating liquid A).

### [Example 1-1]

### (Fabrication of organic EL device 1-1)

A material obtained by subjecting ITO to vapor deposition and film formation in a thickness of 150 nm on a glass substrate of 25 mm × 25 mm × 0.7 mm was prepared as a transparent supporting substrate. This transparent supporting substrate was subjected to etching and washing.

A hole injection layer (PEDOT-PSS solution (polyethylene dioxy thiophene-polystyrene sulfonic acid doped material), manufactured by Bayer AG) was spin-coated on this ITO glass substrate, followed by vacuum drying at 150°C for one hour, thereby preparing a hole injection layer (film thickness: about 40 nm).

The coating liquid A was spin-coated thereon within a glove box (dew point: -68°C, oxygen concentration: 10 ppm), thereby preparing a light emitting layer (film thickness: about 40 nm).

Subsequently, BAlq was vapor deposited in a film thickness of 40 nm, thereon by means of a vacuum vapor deposition method, thereby preparing an electron injection layer.

Then, lithium fluoride was vapor deposited in a thickness of 1 nm thereon, and furthermore, metallic aluminum was vapor deposited in a thickness of 70 nm thereon, thereby preparing a cathode.

The fabricated layered product was placed in an argon gas-substituted glove box and sealed by using a stainless steel-made sealing can and an ultraviolet ray-curable adhesive (XNR5516HV, manufactured by Nagase-Ciba Ltd.).

### [Example 2]

### (Preparation of coating liquid B)

0.23 % by mass of an iridium complex (Ir(ppy)₃), 2.77 % by mass of the following Compound (1) and 97 % by mass of a solvent (solvent obtained by mixing NMP (boiling point: 202°C), 2-n-butoxyethanol (boiling point: 172°C; an azeotropic solvent; azeotropic temperature with water: 79.2°C) and ethylene glycol in a mass ratio of 55/35/10) were mixed to obtain a coating liquid for organic electroluminescence device (coating liquid B).

### [Example 2-1]

### (Fabrication of organic EL device 2-1)

A material obtained by subjecting ITO to vapor deposition and film formation in a thickness of 150 nm on a glass substrate of 25 mm × 25 mm × 0.7 mm was prepared as a transparent supporting substrate. This transparent supporting substrate was subjected to etching and washing.

A hole injection layer (PEDOT-PSS solution (polyethylene dioxy thiophene-polystyrene sulfonic acid doped material), manufactured by Bayer AG) was spin-coated on this ITO glass substrate, followed by vacuum drying at 100°C for one hour, thereby preparing a hole injection layer (film thickness: about 40 nm).

The coating liquid B was spin-coated thereon within a glove box (dew point: -68°C, oxygen concentration: 10 ppm), thereby preparing a light emitting layer (film thickness: about 40 nm).

Subsequently, BAlq was vapor deposited in a film thickness of 40 nm thereon by means of a vacuum vapor deposition method, thereby preparing an electron injection layer.

Then, lithium fluoride was vapor deposited in a thickness of 1 nm thereon, and furthermore, metallic aluminum was vapor deposited in a thickness of 70 nm thereon, thereby preparing a cathode.

The fabricated layered product was placed in an argon gas-substituted glove box and sealed by using a stainless steel-made sealing can and an ultraviolet ray-curable adhesive (XNR5516HV, manufactured by Nagase-Ciba Ltd.).

### [Comparative Example 1]

### (Preparation of coating liquid C)

0.15 % by mass of an iridium complex (Ir(ppy)₃), 2.85 % by mass of the following Compound (1) and 97 % by mass of a solvent (solvent obtained by mixing DMI (Bp = 220°C) and 2-methoxyethanol (Bp = 125°C, azeotropic temperature: 99.9°C) in a mass ratio of 60/40) were mixed to obtain a coating liquid for organic electroluminescence device (coating liquid C).

### [Comparative Example C1-1]

### (Fabrication of comparative organic EL device C1-1)

A comparative organic EL device C1-1 was fabricated in the same manner as that in Example 1-1, except for changing the coating liquid A of Example 1-1 to the coating liquid C.

### [Comparative Example 2]

### (Preparation of coating liquid D)

0.15 % by mass of an iridium complex (Ir(ppy)₃), 2.85 % by mass of the following Compound (1) and 97 % by mass of a solvent (chloroform (boiling point: 61.15°C; an azeotropic solvent; azeotropic temperature with water: 56.1°C)) were mixed to obtain a coating liquid for organic electroluminescence device (coating liquid D).

### [Comparative Example C2-1]

### (Fabrication of comparative organic EL device C2-1)

A comparative organic EL device C2-1 was fabricated in the same manner as that in Example 1-1, except for changing the coating liquid A of Example 1-1 to the coating liquid D.

The compounds and the like used in the devices of Examples 1-1 and 2-1 and Comparative Examples C1-1 and C2-1 are shown below.

**Table 1**

| | Anode | Hole transport layer | Light emitting layer | | Electron injection layer | Cathode |
|---|---|---|---|---|---|---|
| | | | First solvent/ second solvent/ (third solvent) | Light emitting material/ host material | | |
| Example 1-1 | ITO | PEDOT-PSS (40 nm) | NMP/ 2-n-butoxyethanol (mass ratio: 60/40) | Ir(ppy)₃/ Compound 1 (40 nm) | Balq (40 nm) | LiF/Al (1 nm/70 nm) |
| Example 2-1 | ITO | PEDOT-PSS (40 nm) | NMP/ 2-n-butoxyethano/ ethylene glycol (mass ratio: 55/35/10) | Ir(ppy)₃/ Compound 1 (40 nm) | Balq (40 nm) | LiF/Al (1 nm/70 nm) |
| Comparative Example C1-1 | ITO | PEDOT-PSS (40nm) | DMI/ 2-methoxyethanol (mass ratio: 60/40) | Ir(ppy)₃/ Compound 1 (40 nm) | Balq (40nm) | LiF/Al (1 nm/70 nm) |
| Comparative Example C2-1 | ITO | PEDOT-PSS (40 nm) | Chloroform | Ir(ppy)₃/ Compound 1 (40nm) | Balq (40 nm) | LiF/Al (1 nm/70 nm) |

| | | | | | | |
|---|---|---|---|---|---|---|
| NMP: N-Methyt-2-pyrrolidone DMI: 1,3-Dimethyl-2-imidazolidinone | | | | | | |

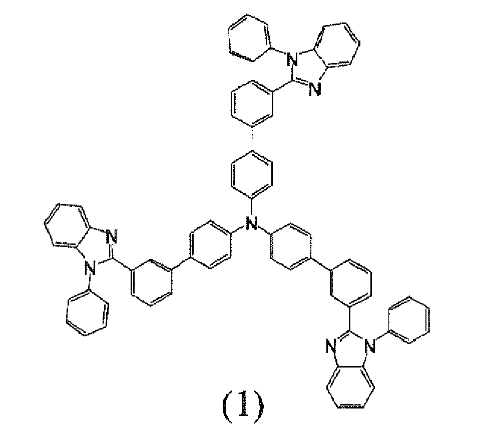

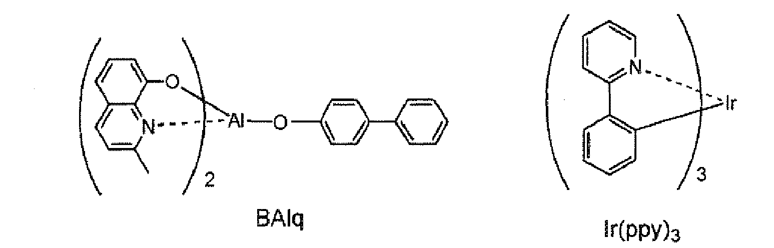

### (Performance evaluation)

### (1) Durability:

A constant current was impressed to the OLED device at an initial light emission luminance of 500 cd/m² and at room temperature; driving was continuously performed; a time until the light emission luminance dropped to 1/2 was measured; and comparison and contrast were performed on the basis of Comparative Example C1-1 as shown in Table 2. Evaluation criteria are as follows.
A: The time is 5 times or more long as compared with the time until the light emission luminance of Comparative Example C1-1 dropped to 1/2.
B: The time falls within a range of 3 times or more and less than 5 times as compared with the time until the light emission luminance of Comparative Example C1-1 dropped to 1/2.
C: The time falls within a range of 0.3 times or more and less than 3 times as compared with the time until the light emission luminance of Comparative Example C1-1 dropped to 1/2.
D: The time is less than 0.3 times short as compared with the time until the light emission luminance of Comparative Example C1-1 dropped to 1/2.

### (2) Efficiency:

A light emission luminance at a driving current density of 2.5 mA/cm² was measured.
As to a measurement method, a spectral radiance in the front of the organic EL device was measured using a spectral radiance meter (CS-1000, manufactured by Konica Minolta Holdings, Inc.), and an external quantum efficiency was calculated. Comparison and contrast were performed on the basis of Comparative Example C1-1 as shown in Table 2. Evaluation criteria are as follows.
A: The external quantum efficiency is 5 times or more as compared with the external quantum efficiency of Comparative Example C1-1.
B: The external quantum efficiency falls within a range of 2 times or more and less than 5 times as compared with the external quantum efficiency of Comparative Example C1-1.
C: The external quantum efficiency falls within a range of 0.5 times or more and less than 2 times as compared with the external quantum efficiency of Comparative Example C1-1.
D: The external quantum efficiency is less than 0.5 times as compared with the external quantum efficiency of Comparative Example C1-1.

### (Evaluation results)

The obtained results are shown in Table 2.

**Table 2**

| | | Durability | Efficiency |
|---|---|---|---|
| Example | 1-1 | B | B |
| | 2-1 | B | B |
| Comparative Example | C1-1 | C | C |
| | C2-1 | D | C |

As a result of the evaluation, it was noted that the organic EL device of the invention has high durability and excellent efficiency.

### [Comparative Example 3]

### (Preparation of coating liquid E-1)

0.15 % by mass of an iridium complex (G-1), 2.85 % by mass of a host compound H-1 and 97 % by mass of a solvent (chloroform) were mixed to obtain a coating liquid for organic electroluminescence device (coating liquid E-1).

### (Fabrication of comparative organic EL device E-1)

A comparative organic EL device E-1 was fabricated in the same manner as that in Example 1-1, except for changing the coating liquid A of Example 1-1 to the coating liquid E-1.

### (Preparation of coating liquids E-2 to E-4)

0.15 % by mass of an iridium complex (G-1), 2.85 % by mass of a host compound (H-13) and 97 % by mass of, as a solvent, chloroform, dichlorobenzene (boiling point: 180.48°C; an azeotropic solvent; azeotropic temperature with water: 90°C) and THF (tetrahydrofuran) (boiling point: 66°C; an azeotropic solvent; azeotropic temperature with water: 64°C), respectively were mixed to obtain coating liquids for organic electroluminescence device (coating liquids E-2 to E-4).

### (Fabrication of comparative organic EL devices E-2 to E-4)

Comparative organic EL devices E-2 to E-4 were fabricated in the same manner as that in Example 1-1, except for changing the coating liquid A of Example 1-1 to the coating liquids E-2 to E-4, respectively.

### (Performance evaluation)

The comparative examples E-2 to E-4 were evaluated in the same manner as that in Example 1 on the basis of the comparative example E-1.

### [Example 3]

### (Preparation of coating liquid E)

0.15 % by mass of the following light emitting material, 2.85 % by mass of a host compound and 97 % by mass of a solvent (solvent obtained by mixing NMP (boiling point: 202°C) and 2-n-butoxyethanol (boiling point: 172°C; an azeotropic solvent; azeotropic temperature with water: 79.2°C) in a mass ratio of 60/40) were mixed to obtain a coating liquid for organic electroluminescence device (coating liquid E).

**Table 3**

| Sample No. | Light emitting material | Host compound |
|---|---|---|
| 3-1 | G-1 | H-1 |
| 3-2 | G-7 | H-1 |
| 3-3 | G-13 | H-1 |
| 3-4 | G-24 | H-1 |
| 3-5 | G-1 | H-7 |
| 3-6 | G-7 | H-13 |
| 3-7 | G-13 | H-15 |
| 3-8 | G-1 | H-13 |

### [Examples 3-1 to 3-8]

### (Fabrication of organic EL device 3-1)

A material obtained by subjecting ITO to vapor deposition and film formation in a thickness of 150 nm on a glass substrate of 25 mm × 25 mm × 0.7 mm was prepared as a transparent supporting substrate. This transparent supporting substrate was subjected to etching and washing.

A hole injection layer (PEDOT-PSS solution (polyethylene dioxy thiophene-polystyrene sulfonic acid doped material), manufactured by Bayer AG) was spin-coated on this ITO glass substrate, followed by vacuum drying at 150°C for one hour, thereby preparing a hole injection layer (film thickness: about 40 nm).

The coating liquid E was spin-coated thereon within a glove box (dew point: -68°C, oxygen concentration: 10 ppm), thereby preparing a light emitting layer (film thickness: about 40 nm).

Subsequently, BAlq was vapor deposited in a film thickness of 40 nm thereon by means of a vacuum vapor deposition method, thereby preparing an electron injection layer.

Then, lithium fluoride was vapor deposited in a thickness of 1 nm thereon, and furthermore, metallic aluminum was vapor deposited in a thickness of 70 nm thereon, thereby preparing a cathode.

The fabricated layered product was placed in an argon gas-substituted glove box and sealed by using a stainless steel-made sealing can and an ultraviolet ray-curable adhesive (XNR5516HV, manufactured by Nagase-Ciba Ltd.).

### (Fabrication of organic EL devices 3-2 to 3-8)

Organic EL devices 3-2 to 3-8 were fabricated in the same manner as that in the fabrication of the organic EL device 3-1, except for changing the light emitting material and the host material in the coating liquid E used in the fabrication of the organic EL device 3-1 from 3-1 to 3-2 to 3-8 as shown in Table 3, respectively.

### (Performance evaluation)

The same evaluation as that in Example 1 was carried out on the basis of Comparative Example E-1.

### (Evaluation results)

The obtained results are shown in Table 4.

**Table 4**

| | Sample | Durability | Efficiency |
|---|---|---|---|
| Example | 3-1 | B | B |
| | 3-2 | B | A |
| | 3-3 | A | A |
| | 3-4 | A | B |
| | 3-5 | A | A |
| | 3-6 | B | B |
| | 3-7 | A | B |
| | 3-8 | B | A |
| Comparative Example | E-2 | D | D |
| | E-3 | D | D |
| | E-4 | D | C |

### [Example 4]

### (Preparation of coating liquid F)

0.23 % by mass of an iridium complex (Ir(ppy)₃), 2.77 % by mass of the foregoing Compound (1) and 97 % by mass of a solvent (solvent obtained by mixing DMI (boiling point: 220°C) and 2-n-butoxyethanol (boiling point: 172°C; an azeotropic solvent; azeotropic temperature with water: 79.2°C) in a mass ratio of 80/20) were mixed to obtain a coating liquid for organic electroluminescence device (coating liquid F).

### [Example 4-1]

### (Fabrication of organic EL device 4-1)

A material obtained by subjecting ITO to vapor deposition and film formation in a thickness of 150 nm on a glass substrate of 25 mm × 25 mm × 0.7 mm was prepared as a transparent supporting substrate. This transparent supporting substrate was subjected to etching and washing.

A hole injection layer (PEDOT-PSS solution (polyethylene dioxy thiophene-polystyrene sulfonic acid doped material), manufactured by Bayer AG) was spin-coated on this ITO glass substrate, followed by vacuum drying at 100°C for one hour, thereby preparing a hole injection layer (film thickness: about 40 nm).

The coating liquid F was spin-coated thereon within a glove box (dew point: -68°C, oxygen concentration: 10 ppm), followed by vacuum drying at 120°C for one hour, thereby preparing a light emitting layer (film thickness: about 40 nm).

Subsequently, BAlq was vapor deposited in a film thickness of 40 nm thereon by means of a vacuum vapor deposition method, thereby preparing an electron injection layer.

Then, lithium fluoride was vapor deposited in a thickness of 1 nm thereon, and furthermore, metallic aluminum was vapor deposited in a thickness of 70 nm thereon, thereby preparing a cathode.

The fabricated layered product was placed in an argon gas-substituted glove box and sealed by using a stainless steel-made sealing can and an ultraviolet ray-curable adhesive (XNR5516HV, manufactured by Nagase-Ciba Ltd.).

### [Example 5]

### (Preparation of coating liquid G)

0.23 % by mass of an iridium complex (IrCppy)₃), 2.77 % by mass of the foregoing Compound (1) and 97 % by mass of a solvent (solvent obtained by mixing DMI (boiling point: 220°C) and methyl ethyl ketone (boiling point: 79.5°C; an azeotropic solvent; azeotropic temperature with water: 73.6°C) in a mass ratio of 50/50) were mixed to obtain a coating liquid for organic electroluminescence device (coating liquid G).

### [Example 5-1]

### (Fabrication of organic EL device 5-1)

A material obtained by subjecting ITO to vapor deposition and film formation in a thickness of 150 nm on a glass substrate of 25 mm × 25 mm × 0.7 mm was prepared as a transparent supporting substrate. This transparent supporting substrate was subjected to etching and washing.

A hole injection layer (PEDOT-PSS solution (polyethylene dioxy thiophene-polystyrene sulfonic acid doped material), manufactured by Bayer AG) was spin-coated on this ITO glass substrate, followed by vacuum drying at 100°C for one hour, thereby preparing a hole injection layer (film thickness: about 40 nm).

The coating liquid G was spin-coated thereon within a glove box (dew point: -68°C, oxygen concentration: 10 ppm), followed by vacuum drying at 120°C for one hour, thereby preparing a light emitting layer (film thickness: about 40 nm).

Subsequently, BAlq was vapor deposited in a film thickness of 40 nm thereon by means of a vacuum vapor deposition method, thereby preparing an electron injection layer.

Then, lithium fluoride was vapor deposited in a thickness of 1 nm thereon, and furthermore, metallic aluminum was vapor deposited in a thickness of 70 nm thereon, thereby preparing a cathode.

The fabricated layered product was placed in an argon gas-substituted glove box and sealed by using a stainless steel-made sealing can and an ultraviolet ray-curable adhesive (X-NR5516HV, manufactured by Nagase-Ciba Ltd.).

### (Performance evaluation)

The same evaluation as that in Example 1 was carried out on the basis of Comparative Example E-1.

### (Evaluation results)

The obtained results are shown in Table 5.

**Table 5**

| | Efficiency | Durability |
|---|---|---|
| Example 4-1 | B | B |
| Examples 5-1 | B | B |

As a result of the evaluation, it was noted that the organic EL device using the coating liquid of the invention has high durability and excellent efficiency.

### INDUSTRIAL APPLICABILITY

According to the invention, it is possible to provide a coating liquid for organic electroluminescence device capable of fabricating an organic electroluminescence device with satisfactory durability and excellent efficiency.

Also, according to the invention, it is possible to provide a method for manufacturing an organic electroluminescence device with satisfactory durability and excellent efficiency.

Furthermore, according to the invention, it is possible to provide an organic electroluminescence device with satisfactory durability and excellent efficiency.

While the invention has been described in detail and with reference to specific embodiments thereof, it will be apparent to one skilled in the art that various changes and modifications can be made therein without departing from the spirit and scope thereof.

This application is based on a Japanese patent application (No. 2009-80269) filed on March 27, 2009 and a Japanese patent application (No. 2009-190481) filed on August 19, 2009, the contents of which are incorporated herein by reference.

### DESCRIPTION OF LETTERS OR NUMERALS

1: Base material
2: Transparent electrode
3: Organic layer
4: Back electrode
5: Transparent electrode lead
6: Back electrode lead
7: Light emitting layered product
8: Sealing agent (adhesive)
9: Sealing member
10: Space

## Claims

1. A coating liquid for organic electroluminescence device for forming an organic layer including a light emitting layer between a pair of electrodes, which comprises a first solvent and a second solvent,
wherein
the first solvent is at least one member selected from solvents capable of dissolving a light emitting material and a host material contained in the light emitting layer and having a boiling point of 200°C or higher,
the second solvent is at least one member selected from solvents having an azeotropic temperature with water of 99°C or less, and
a relation between a boiling point (BP1) of the first solvent and a boiling point (BP2) of the second solvent is BP1 ≥ BP2.

2. The coating liquid for organic electroluminescence device according to claim 1, wherein a mass ratio of used amounts of the first solvent and the second solvent is from 50:50 to 95:5.

3. The coating liquid for organic electroluminescence device according to claim 1 or 2, wherein the first solvent is an amide based solvent.

4. The coating liquid for organic electroluminescence device according to any one of claims I to 3, which further comprises a polyhydric alcohol as a third solvent.

5. The coating liquid for organic electroluminescence device according to claim 4, wherein the polyhydric alcohol is at least one member selected from ethylene glycol, diethylene glycol and glycerin.

6. The coating liquid for organic electroluminescence device according to claim 4 or 5, wherein a content of the third solvent is from 5 % by mass to 40 % by mass relative to a total amount of the coating liquid.

7. A method for manufacturing an organic electroluminescence device, which comprises:
a step of forming a first electrode on a substrate;
a step of coating a coating liquid for organic electroluminescence device described in any one of claims 1 to 6 on the substrate having the first electrode formed thereon, to form an organic layer; and
a step of forming a second electrode on the organic layer.

8. An organic electroluminescence device comprising an organic layer between a pair of electrodes, wherein at least one organic layer is formed from a coating liquid for organic electroluminescence device described in any one of claims 1 to 6.

9. An organic electroluminescence device comprising an organic layer between a pair of electrodes, wherein the organic electroluminescence device is manufactured by a method for manufacturing an organic electroluminescence device described in claim 7.
